(19) **Europäisches Patentamt** / **European Patent Office** / **Office européen des brevets**

(11) **EP 1 897 976 B1**

(12) **EUROPEAN PATENT SPECIFICATION**

(45) Date of publication and mention
of the grant of the patent:
**17.04.2013 Bulletin 2013/16**

(51) Int Cl.:
**C30B 15/36** (2006.01)     **C30B 29/06** (2006.01)

(21) Application number: **07017323.2**

(22) Date of filing: **04.09.2007**

(54) **Method for producing silicon single crystal and method for producing silicon wafer**

Verfahren zur Herstellung eines Siliciumeinkristalls und Verfahren zur Herstellung eines Siliciumwafers

Procédé pour la production d'un monocristal de silicium et de tranches de silicium

(84) Designated Contracting States:
**DE**

(30) Priority: **05.09.2006 JP 2006240855**
**06.03.2007 JP 2007056130**

(43) Date of publication of application:
**12.03.2008 Bulletin 2008/11**

(73) Proprietor: **SUMCO Corporation**
**Tokyo 105-8634 (JP)**

(72) Inventors:
 • **Inami, Shuichi**
   **Tokyo 105-8634 (JP)**
 • **Inoue, Kuniharu**
   **Tokyo 105-8634 (JP)**
 • **Moroishi, Manabu**
   **Tokyo 105-8634 (JP)**
 • **Fukagawa, Tsuguya**
   **Tokyo 105-8634 (JP)**
 • **Kusaba, Nobuhiro**
   **Tokyo 105-8634 (JP)**

(74) Representative: **Bertsch, Florian Oliver**
**Kraus & Weisert**
**Patent- und Rechtsanwälte**
**Thomas-Wimmer-Ring 15**
**80539 München (DE)**

(56) References cited:
**EP-A1- 1 498 516     US-A- 5 769 941**

**Description**

BACKGROUND OF THE INVENTION

1. Field of the Invention

The present invention relates to a silicon single crystal production method by a Czochralski method, and a silicon wafer production method in which the silicon single crystal obtained by the silicon single crystal production method is used.

2. Description of the Related Art

An extent of integration is rapidly increased in a silicon semiconductor integrated circuit element (device), and integrated circuit is further miniaturized, and quest for quality of a silicon wafer in which the devices are formed becomes more severe. Therefore, in a so-called device active region where the devices are formed, crystal defects such as dislocations and existence of metal impurities are strictly restricted. This is because the crystal defects and the metal impurities cause an increase in leakage current and the shortening of carrier lifetime.

Recently, a power semiconductor device is used for use in power supply control. An epitaxial silicon wafer is mainly used as a substrate for the power semiconductor device. In the epitaxial silicon wafer, a silicon single crystal ingot is grown by the Czochralski method (hereinafter referred to as CZ method), the ingot is cut out into silicon wafers, and a silicon epitaxial layer in which the crystal defects are substantially completely eliminated is deposited on a surface of the obtained silicon wafer.

In the substrate for the power semiconductor device, the low-resistivity silicon wafer is demanded because of lower power consumption. The reason why the low-resistance silicon wafer is adopted in the epitaxial wafer is the design standpoint in which a so-called latch-up phenomenon can be prevented with the low-resistance silicon wafer to facilitate the device design, wherein the latch-up phenomenon designates that a floating charge to be generated in a device operation activates a parasitic transistor. In the case where a trench-structure capacitor is used, there is also an advantage that a depletion layer, in applying a voltage to the vicinity of the trench, can be prevented from extending using the low-resistance silicon wafer.

Usually a dopant is doped into the low-resistance silicon wafer with a high concentration. In the case of a p-type silicon wafer, boron (B) which is of a p-type dopant is doped with a high concentration. In the case of an n-type silicon wafer, phosphorous (P), arsenic (As), antimony (Sb), or the like which is of an n-type dopant is doped with a high concentration.

When the silicon single crystal is grown by the CZ method, the dislocations are generated in a seed crystal by heat shock caused at the time that the seed crystal is brought into contact with a silicon melt. Bur in the conventional popular silicon single crystal having a crystal axis [100], the dislocations generated in a necking process can be eliminated.

However, in a silicon single crystal having the crystal axis orientation [110], from the standpoint of crystal structure, because the silicon single crystal having the crystal axis orientation [110] includes a crystal plane {111} which is of a slip plane parallel to a pulling axial direction, the dislocations generated by the contact with the melt surface hardly exit from the seed crystal. Therefore, the dislocations are taken over to the grown crystal through the neck portion, which raises a problem in that the dislocation-free silicon single crystal cannot be grown.

Additionally, with the larger diameter and heavier weight of the silicon single crystal ingot, it is necessary to increase a neck diameter, so that the removal of the dislocations becomes more difficult.

For example, in the case where a single crystal having a diameter of 300 mm is pulled up, while a seed crystal having a diameter of 10 mm or more is used so as to increase its bearable load, a neck diameter gets shrunken such that the neck portion has the diameter ranging from about 4 mm to about 6 mm. However, when the seed crystal having the larger diameter is used, an even temperature distribution is hardly achieved between a central portion and an outer peripheral portion of the seed crystal, and a fluctuation in temperature likely causes the dislocations to be generated. Additionally, a dislocations-generation amount is also increased in the seed crystal by enlarging a contact area with the silicon melt.

In order to solve the above problems, Japanese Patent Application Publication No. 2003-313089 corresponding to EP 1 498 516 A1 proposes a single crystal silicon production method, wherein the silicon single crystal in which the slip dislocations are eliminated in a necking process is obtained by pulling up a seed crystal while the crystal orientation <110> is inclined relative to the axial direction of the seed crystal. When the inclined direction is rotated about another crystal orientaion <110> as being a rotational axis which is in a perpendicular relation with the former crystal orientation <110>, a crystal plane {220} (parallel to crystal plane {110}) which is used as an X-ray diffraction plane in detecting the crystal orientation of the pulled single crystal is parallel to other crystal planes {220} in a <100>-axis crystal and a <111>-axis crystal. Therefore, desirably an X-ray diffraction apparatus and machining apparatus for machining an orientation flat and a notch based on the detected orientation can commonly be used irrespective of the crystal orientation of the pulled single crystal.

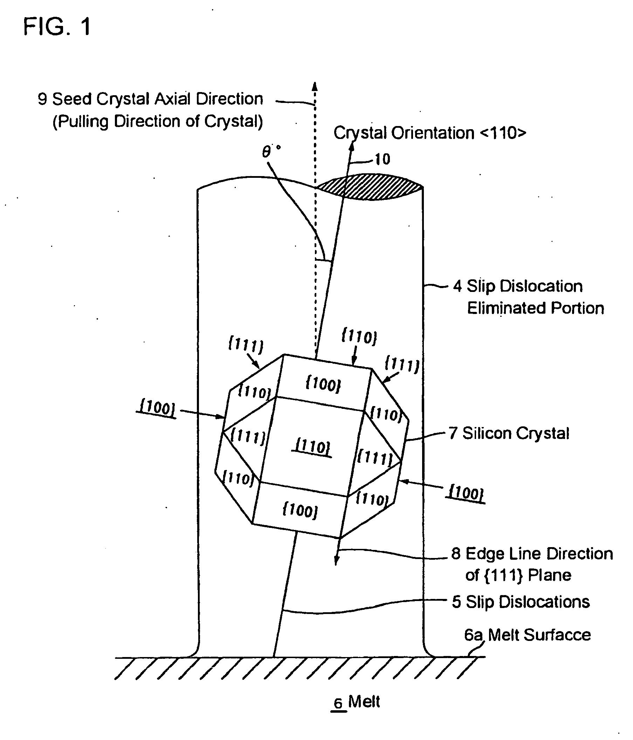

Fig. 1 is a view which is shown as Fig. 2 in Japanese Patent Application Publication No. 2003-313089, and Fig. 1 shows a relationship between the crystal orientation of the silicon crystal and the axial direction of the seed crystal. In Fig. 1, a structure of a silicon crystal 7 is schematically illustrated on the neck portion (slip-dislocation eliminated portion 4 in Fig. 1) in an overlapping fashion where a seed crystal is dipped in a silicon melt 6 and pulled up. The "direction inclined relative to the axial direction of the seed crystal" means a rotationally shifted direction about the axis as another crystal orientation <110> that is in a perpendicular relation with a crystal orientation <110> 10 in Fig. 1, i.e., a direction which is rotated about the normal line to the crystal plane {110} marked up by a bold underline in Fig. 1. As a result of the directional axis rotation, the crystal orientation <110> 10 of the silicon crystal 7 is inclined by $\theta°$ relative to an axial direction (crystal pulling direction) 9 of the seed crystal.

On the other hand, in growing the p-type low-resistance silicon single crystal having a resistivity of 100 mΩcm or less in which the dopant such as boron is doped with a high concentration, when the seed crystal differs from the silicon melt with respect to the dopant concentration, there is a problem in that misfit dislocations are likely generated in the seed crystal by a difference in lattice constant at the time that the seed crystal is brought into contact with the melt.

Therefore, for example, Japanese Patent Application Publication No. 9-255490 proposes an art in which the generation of the dislocations caused by the difference in lattice constant is avoided using the seed crystal having the same level of boron concentration as that in the silicon melt.

Japanese Patent Application Publication No. 2001-240493 discloses a dislocation-free silicon single crystal production method, in which the dislocation-free single crystal is used as the seed crystal and a difference in boron concentration between the seed crystal and the grown crystal is set to a predetermined value or less. However, in growing the silicon single crystal having the crystal axis orientation [110], because the single crystal has the slip plane (crystal plane {111}) in the same direction as the pulling axial direction as described above, the dislocation eliminating effect is not sufficiently obtained.

In the case where the epitaxial growth process is performed using the silicon wafer having the wafer surface of a crystal plane (110), there is also a problem in that a haze of the epitaxial layer surface becomes worsened.

SUMMARY OF THE INVENTION

In view of the foregoing, an object of the invention is to provide a silicon single crystal production method in which the silicon wafer having the crystal axis orientation [110] can be obtained and the dislocations are sufficiently eliminated, a silicon seed crystal used in the silicon single crystal production method, and a method for producing a low-resistivity silicon wafer having the crystal axis orientation [110] from the silicon single crystal obtained by the silicon single crystal production method.

In order to solve the above problems, in consideration of an application to the low-resistance epitaxial silicon wafer mainly used as the substrate for the power semiconductor device, the inventors made the study on the CZ method of adding boron as the dopant to produce the dislocation-free silicon single crystal whose center axis is inclined by a predetermined angle relative to the crystal axis [110] and on the production of the silicon wafer having the crystal axis orientation [110] with the silicon single crystal, thus accomplishing the present invention.

The gist of the invention pertains to a silicon single crystal production method described in (1) below, a silicon wafer production method described in (2) or (3) below, and a silicon seed crystal described in (4).

(1) A first aspect according to the invention provides a method for producing a silicon single crystal by a Czochralski method, in which a center axis thereof is inclined by 0.6° to 10° relative to a crystal axis [110], wherein the silicon single crystal is grown by dipping a silicon seed crystal in a silicon melt, the silicon melt containing boron as a dopant such that a boron concentration ranges from $6.25 \times 10^{17}$ to $2.5 \times 10^{20}$ atoms/cm$^3$, the silicon seed crystal having a center axis that is inclined by 0.6° to 10° relative to the crystal axis [110] and having the substantially same boron concentration as that of a neck portion formed in the single crystal grown from the silicon melt, and furthermore the center axis of the silicon seed crystal is inclined to a direction rotated about a crystal axis <100> perpendicular to the crystal axis [110]. Therefore, when compared with the case in which the center axis of the silicon seed crystal is inclined to other directions, desirably the dislocations can be eliminated during the necking process even if the length of the neck portion is short.

And, in the silicon single crystal production method according to the first aspect of the invention, preferably the neck portion having a diameter of 4 to 6 mm is formed using the seed crystal in which a diameter of a seed crystal lower end portion is not more than 8 mm, the seed crystal lower end portion being in contact with the silicon melt.

In cutting out a silicon wafer from the silicon single crystal obtained by the method according to the first aspect, the silicon single crystal may be obliquely cut at an angle corresponding to the seed crystal inclination angle to obtain the silicon wafer whose surface includes a crystal plane (110),

In cutting out a silicon wafer from the silicon single crystal obtained by the method according to the first aspect, the silicon single crystal may be cut out in such a way that a maximum inclination angle becomes not more than $\pm 10°$ relative to a radial direction of the silicon single crystal.

When an epitaxial layer is formed on a surface of a silicon wafer obtained by the method according to the second or third aspect, the epitaxial silicon wafer in which the haze generation is suppressed can be produced.

(2) A second aspect of the invention provides a silicon seed crystal in which a boron concentration ranges from $5 \times 10^{17}$ to $2 \times 10^{20}$ atoms/cm$^3$ and a center axis is inclined by 0.6° to 10° relative to a crystal axis [110]. That is, desirably the boron concentration of the neck portion formed in the single crystal grown from the silicon melt is estimated from the boron segregation coefficient, and the silicon seed crystal having the substantially same boron concentration as that of the neck portion is used.

In the silicon seed crystal according to the second aspect of the invention, the center axis of the silicon seed crystal is inclined to a direction rotated about a crystal axis <100> perpendicular to the crystal axis [110]. Therefore, when the silicon single crystal is pulled up using the seed crystal, the length of the neck portion in which the dislocations are eliminated can be shortened.

According to the silicon single crystal production method of the invention, the silicon single crystal, in which the generation of the misfit dislocations is suppressed, the dislocations that are hardly taken out in the necking process are sufficiently eliminated, and the center axis is inclined by 0.6° to 10° relative to the crystal axis [110] can be produced. The silicon seed crystal of the invention is particularly suitable to the implementation of this method of the invention.

According to the silicon wafer production method of the invention, the dislocation-free low-resistance silicon wafer having the crystal axis orientation [110] can be produced. The wafer in which the haze generation is suppressed in the epitaxial layer surface formed on the wafer surface can also be produced.

BRIEFD ESCRIPTION OF THE DRAWING

Fig. 1 is a view explaining a relationship between a crystal orientation of a silicon crystal and an axial direction of a seed crystal.

DETAILED DESCRIPTION OF THE PREFERRED EMBODIMENTS

A silicon single crystal production method, a silicon seed crystal used in producing the silicon single crystal, and a silicon wafer production method according to exemplary embodiments of the invention, which are summarized in foregoing (1) through (4) will be recited as below.

The silicon single crystal production method of the invention shown in foregoing (1) is a silicon single crystal production method in which the CZ method is used, wherein, boron as a dopant is added to the silicon melt such that the concentration becomes a range of $6.25 \times 10^{17}$ to $2.5 \times 10^{20}$ atoms/cm$^3$, and the silicon seed crystal whose center axis is inclined by 0.6° to 10° relative to the crystal axis [110] is dipped in the silicon melt to grow the silicon single crystal.

Namely, because the seed crystal is pulled up while the slip plane (crystal plane {111}) is inclined relative to the growth direction (i.e., pulling axial direction), any thermal shock dislocation introduced to an outer peripheral portion of the seed crystal moves on the slip plane, and the thermal shock dislocations are released from a neck side face during the necking. As a result, the dislocation-free silicon single crystal in which the dislocations are sufficiently eliminated can be produced. The center axis of the silicon single crystal is inclined by 0.6° to 10° relative to the crystal axis [110].

The reason why the seed crystal inclination angle is set in the range is as follows.

Assuming that the neck portion has a diameter of 6 mm during the necking, a length (L) of the neck portion necessary to release the dislocations on the slip plane from the neck side face is determined. Table 1 shows the result.

Table 1

| $\theta(°)$ | 0.4 | 0.5 | 0.6 | 0.7 | 1 | 1.5 | 2 | 3 | 10 | 20 | 45 | 90 |
|---|---|---|---|---|---|---|---|---|---|---|---|---|
| L(mm) | 1052 | 842 | 701 | 601 | 420 | 281 | 210 | 140 | 41.9 | 20.6 | 8.48 | 4.24 |
| $\tan\phi$ | $5.70 \times 10^{-3}$ | $7.13 \times 10^{-3}$ | $8.55 \times 10^{-3}$ | $9.88 \times 10^{-3}$ | $1.43 \times 10^{-2}$ | $2.14 \times 10^{-2}$ | $2.85 \times 10^{-2}$ | $4.28 \times 10^{-2}$ | $1.43 \times 10^{-1}$ | $2.91 \times 10^{-1}$ | $7.07 \times 10^{-1}$ | 1.41 |
| $\phi(°)$ | 0.33 | 0.41 | 0.49 | 0.57 | 0.82 | 1.22 | 1.63 | 2.45 | 8.15 | 16.20 | 35.26 | 54.70 |

Where, in the case where the rotation is performed about the crystal axis <100> (more specifically, [001] or [00-1]) perpendicular to the crystal axis {111}, $\theta$ is an angle (hereinafter referred to as "inclination angle of seed crystal" or simply "inclination angle") formed by the crystal axis [110] and the center axis of the seed crystal, and $\phi$ is an angle formed by the slip plane {111} (specifically, four crystal planes of (-111), (1-11), (1-1-1), and (-11-1)) and the center axis of the seed crystal. A relationship between θ and ϕ is expressed by the following equation (a).

$$\tan \emptyset = \frac{\sin \theta \, \sin 54.74}{\sqrt{\cos^2 54.74 + \sin^2 54.74 \, \cos^2 \theta}} \qquad \cdots \qquad (a)$$

In order to cut out the silicon single crystal grown in the above manner to yield wafers whose surfaces have the crystal plane (110), it is necessary that the center axis of the silicon single crystal be set to be inclined relative to a wire saw. The cut-out wafer is outlined not in a true circle but in an ellipse. A minor axis of the ellipse becomes the diameter after the excess portion is rounded to obtain the true circle. A major axis varies depending on the seed crystal inclination angle.

Table 2 shows a relationship between the seed crystal inclination angle (θ) and the major axis (b) in the case of the silicon single crystal having a diameter of 300 mm.

Table 2

| θ(°) | 0.4 | 0.5 | 0.6 | 0.7 | 1 | 10 | 20 |
|------|------|------|------|------|------|------|------|
| b(mm) | 300.007 | 300.011 | 300.016 | 300.022 | 300.046 | 304.628 | 319.253 |

A flattened portion of the cut-out wafer becomes a work loss portion which is ground to obtain the true circle after the cut-out (hereinafter also referred to as "slice").

A runout margin is generated because the silicon single crystal is set in the wire saw while the center axis of the silicon single crystal is inclined. The runout margins shown in Table 3 are obtained in the case of a block length of 300 mm. The block length is a length of a block obtained by cutting single crystal ingot in a proper length as described hereinafter, and the block length is set to the diameter of the silicon single crystal. The work length necessary for the cut-out is slightly increased because the block is obliquely set, and the runout margin means the increased margin.

Table 3 shows a relationship between the seed crystal inclination angle (θ) and the runout margin (D) in the case where the silicon single crystal has a diameter of 300 mm.

Table 3

| θ (°) | 0.4 | 0.5 | 0.6 | 0.7 | 1 | 10 | 20 |
|------|------|------|------|------|------|------|------|
| D(mm) | 2.09 | 2.62 | 3.67 | 3.67 | 5.24 | 52.09 | 102.6 |

A processing capacity to be able to slice the crystal having at least the width of "D+300 mm" in which the runout margin D shown in Table 3 is added to 300 mm is required in order to slice the silicon single crystal having the diameter of 300 mm.

Taking comprehensively into account the neck portion length L, the work loss for rounding the ellipse into the true circle, and the runout margin D, which are shown in Tables 1 to 3, the inclination angle of the seed crystal is set in the range of 0.6° to 10°, more desirably in the range of 1 to 10°. When the inclination angle is smaller than 0.6°, the length of the neck portion for eliminating the dislocations becomes excessively long and the dislocation eliminating effect is not sufficiently obtained either. When the inclination angle is larger than 10°, a degree of flattening becomes larger after the slicing, the work loss portion is increased, and the required processing capacity of the wire saw becomes excessively large.

In the invention, the direction in which the seed crystal is inclined may be the direction in which the slip plane {111} is inclined relative to the pulling axis. For example, when the seed crystal center axis is inclined relative to the crystal axis [110], the seed crystal center axis may be inclined into the direction different from the direction of the crystal axis <111> (more particularly, crystal axes [-11-1], [1-11], [1 -1 -1], and [-111]) perpendicular to the crystal axis [110] (exactly, the direction rotated about the crystal axis <111>). The seed crystal center axis may be inclined into the direction rotated about the crystal axis <100> like the direction of the crystal axis <111> (more particularly, crystal axes [001] and [00-1]) perpendicular to the crystal axis [110], i.e., the case in which the results shown in Table 1 are obtained.

When the silicon seed crystal center axis is inclined into the direction about the crystal axis <100> perpendicular to the crystal axis [110], the length (L) of the neck portion for eliminating the dislocations during the necking can be shortened as described below, and the restriction can be alleviated in pulling the single crystal, which is desireable.

The "direction rotated about the crystal axis <100> perpendicular to the crystal axis [110]" means the direction rotated about the orientation of the crystal plane {100} shown by the bold underline line in Fig. 1. That is, in the state of θ=0°, the "direction rotated about the crystal axis <100> perpendicular to the crystal axis [110]" is the direction in which rotation is made in a direction normal (lift-off or back-off direction) to the paper face in Fig. 1 while the normal line to said crystal plane {100} is set as the rotational axis.

Table 1 as above shows the neck portion length (L) in the case where the direction in which the seed crystal center axis is inclined relative to the crystal axis [110] is set to the direction rotated about the crystal axis <100> perpendicular to the crystal axis [110]. For example, as described in Japanese Patent Application Publication No. 2003-313089, in the case where the seed crystal center axis is inclined into direction rotated about another crystal orientation <110> perpendicular to the crystal orientation <110>, the relationship between α and φ is expressed by the following equation (b). Where α is a seed crystal inclination angle, and α corresponds to θ in said equation (a). The φ is an angle formed by the slip plane {111} and the seed crystal center axis.

$$\tan \phi = \frac{\sin\alpha \, \sin 35.26}{\sqrt{\cos^2 35.26 + \sin^2 35.26 \, \cos^2\alpha}} \quad \cdots \quad (b)$$

As with said Table 1, the neck portion length (L) is computed using the equation (b). Table 4 shows the computation results.

Table 4

| α(°) | 0.4 | 0.5 | 0.6 | 0.7 | 1 | 1.5 | 2 | 3 | 10 |
|---|---|---|---|---|---|---|---|---|---|
| L(mm) | 1488 | 1190 | 994 | 850 | 596 | 396 | 299 | 199 | 59.6 |
| tanφ | $4.03 \times 10^{-3}$ | $5.04 \times 10^{-3}$ | $6.05 \times 10^{-3}$ | $7.05 \times 10^{-3}$ | $1.01 \times 10^{-2}$ | $1.51 \times 10^{-2}$ | $2.02 \times 10^{-2}$ | $3.02 \times 10^{-2}$ | $1.01 \times 10^{-1}$ |
| φ(°) | 0.231 | 0.289 | 0.346 | 0.404 | 0.577 | 0.866 | 1.15 | 1.73 | 5.75 |

In comparison of the neck portion lengths (L) shown in Tables 1 and 4, the neck portion length (L) of Table 1 is much shorter than that of Table 4. Therefore, in the case where the direction in which the seed crystal center axis is inclined relative to the crystal axis [110] is set to the direction rotated about the crystal axis <100> perpendicular to the crystal axis [110], the length (L) of the neck portion in which the dislocations can be eliminated can be shortened.

When the comparison is made while the inclination angle is actually set to 6° or 10° based on the above result, it can be confirmed that the length (L) of the neck portion in which the dislocations can be eliminated can be shortened, in the case where the seed crystal inclination direction is set to the direction rotated about the crystal axis <100> perpendicular to the crystal axis [110].

In the silicon single crystal production method of the invention, the silicon seed crystal having the same boron concentration as that of the neck portion formed in the single crystal grown from the silicon melt is dipped in the silicon melt into which boron as the dopant is added such that the boron concentration ranges from $6.25 \times 10^{17}$ to $2.5 \times 10^{20}$ atoms/cm$^3$.

In growing the p-type low-resistance silicon single crystal, the misfit dislocations are likely generated in the seed crystal due to the difference in lattice constant caused by the difference in dopant concentration between the seed crystal and the silicon melt. However, in the invention, the generation of the misfit dislocations which becomes troublesome in growing the low-resistance silicon single crystal can be suppressed by substantially equalizing the boron concentration of the seed crystal to the boron concentration of the neck portion of the crystal grown from the silicon melt.

The substantially equal concentration means that desirably one of the seed crystal and the neck portion of the crystal grown from the silicon melt has the boron concentration within the range of 10 to 1000% (i.e., multiplied by 0.1 to 10) relative to the boron concentration of the other. When the difference in boron concentration exists within the above range, the effect of suppressing the generation of the misfit dislocations is exhibited.

That the boron concentrations of the seed crystal and the neck portion of the crystal grown from the silicon melt are defined as described above is based on the after-mentioned results of Examples.

In the silicon seed crystal applied to the invention, the boron concentration ranges from $5 \times 10^{17}$ to $2 \times 10^{20}$ atoms/cm$^3$, and the center axis is inclined by 0.6° to 10° relative to the crystal axis [110].

In the silicon single crystal production method of the invention, the seed crystal having the substantially same boron concentration as that of the neck portion of the crystal grown from the silicon melt is used as the silicon seed crystal. When the seed crystal having the substantially same boron concentration is used, the difference in lattice constant between the seed crystal and the grown crystal can be eliminated to further increase the effect of suppressing the generation of the misfit dislocations.

That is, in consideration of a boron segregation coefficient, the boron concentration of the neck portion of the single crystal grown from the silicon melt is estimated from the boron segregation coefficient, and the silicon seed crystal having the substantially same boron concentration of $5 \times 10^{17}$ to $2 \times 10^{20}$ atoms/cm$^3$ is desirably used.

In the silicon single crystal production method of the invention, the seed crystal whose diameter is not more than 8 mm in a lower end portion being in contact with the silicon melt is used to form the neck portion having a diameter of 4 to 6 mm. Because a contact area with the melt is small, the seed crystal temperature can sufficiently be homogenized by pre-heating. Therefore, desirably a dislocation generation amount can further be decreased.

In the silicon wafer production method according to the second aspect of the invention described in foregoing (2), in cutting out the wafer from the low-resistivity silicon single crystal obtained by the silicon single crystal production method of the invention, the silicon single crystal is obliquely cut at an angle corresponding to the seed crystal inclination angle to obtain the silicon wafer whose surface includes the crystal plane (110).

Because the silicon single crystal is obliquely cut at the angle corresponding to the seed crystal inclination angle to obtain the silicon wafer whose surface includes the crystal plane (110), the dislocation-free low-resistance silicon wafer can be produced with the crystal axis orientation [110].

In the silicon wafer production method according to the third aspect of the invention as described in foregoing (3), in cutting out the wafer from the low-resistivity silicon single crystal obtained by the silicon single crystal production method of the invention, the silicon single crystal is cut such that the maximum inclination angle becomes not more than $\pm 10°$ relative to a radial direction (direction parallel to an end face of the single crystal) of the silicon single crystal.

The dislocation-free low-resistance silicon wafer whose crystal axis is inclined relative to the crystal axis [110] can be produced by cutting the silicon single crystal in the above manner. The silicon wafer surface does not include the crystal plane (110), so that the haze generation which becomes troublesome during the epitaxial growth process can be suppressed in the epitaxial layer surface.

The outlining process flow for producing the silicon wafer by the silicon single crystal production method of the invention will be described below.

First, external grinding is performed for the pulled silicon single crystal (ingot). In consideration of the quality demand and a diameter fluctuation generated by disturbance during the pull-up, the ingot is pulled up while the ingot diameter is larger than the target wafer diameter by several percent. Therefore, the ingot is ground to the target diameter by the external grinding.

Then, the shoulder portion and the tail portion of the ingot are cut away, and the ingot is further cut into blocks each having a proper length.

Then, the block is bonded to a carbon base, and the block is set in the wire saw while the center axis of the block is inclined. At this point, the crystal orientation is measured with an X-ray diffraction apparatus, and the block is set in such a way that the sliced surface includes the crystal plane (110) after the slicing or in such a way that the maximum inclination angle becomes not more than $\pm 10°$ relative to the radial direction of the silicon single crystal. Then the block is cut with the wire saw.

Because the sliced wafer has the flattened ellipsoid shape, the excess portion is ground to obtain the true circle. Then, the surface of the wafer is processed to a mirror surface by polishing.

EXAMPLES

(Example 1)

The silicon single crystals are grown under the following conditions, and the presence or absence of the dislocations in the single crystal is investigated. The number of pulled silicon single crystals is set to three for each level of the boron concentration in the silicon crystal and the seed crystal inclination angle as well.

The boron concentration of the silicon seed crystal is designated by the conveniently used expression. A sign "+" or "++" appended to "p" indicates that the dopant concentration (in this case, boron concentration) is high while the crystal resistivity is low, and the sign "-" indicates the opposite. There is no clear definition for the dopant concentration and resistivity. In this case, the p+ and p++ in which the dopant concentration is particularly increased are defined as follows.

p+: boron concentration ranging from $5 \times 10^{17}$ to $7 \times 10^{18}$ atoms/cm$^3$ and resistivity ranging from 100 to 20 m$\Omega$cm

p++: boron concentration ranging from $7 \times 10^{18}$ to $2 \times 10^{20}$ atoms/cm$^3$ and resistivity ranging from 20 to 0.8 m$\Omega$cm

In order to grow the p+ or p++ single crystal, it is necessary that the dopant concentration in the melt become the figure multiplied by "1/segregation coefficient" (1/0.8=1.25 multiplied: in the case of boron) in consideration of the segregation phenomenon.

(Crystal Growth Condition)

Crystal axis orientation: <110>
Single crystal diameter: 300 mm
Crystal growth boron concentration: p-, p, p+, p++
Seed crystal boron concentration: p
Seed crystal inclination angle: 0°, 0.7°, 1°, 5°, 10°
Neck portion length: 300 mm

Table 5 shows the investigation result. In evaluation of Table 5, a sign "○" indicates that all the three silicon single crystals can be grown in a dislocation-free manner, a sign "Δ" indicates that a part of the silicon single crystals has the dislocations, and a sign "×" indicates that all the single crystals have the dislocations. The same holds true for the Examples 2 to 4.

Table 5

|  | seed crystal inclination angle (°) | boron concentration of grown crystal | | |
|---|---|---|---|---|
|  |  | p- | p+ | p++ |
| condition 1 | 0 | Δ | × | × |
| condition 2 | 0.7 | ○ | × | × |
| condition 3 | 1.0 | ○ | × | × |
| condition 4 | 5.0 | ○ | Δ | × |
| condition 5 | 10.0 | ○ | Δ | × |

As is evident from Table 5, under the condition 1 in which the growth is made while the seed crystal center axis is not inclined (inclination angle: 0°), in the case of the relatively-high-resistance silicon single crystal grown with the silicon melt having the low boron concentration such as the p- crystal, although a part of the silicon single crystals can be grown with dislocation free, the dislocations exist in all the p+ and p++ silicon single crystals (low-resistance crystal).
Under the conditions 2 to 5 in which the growth is made while the seed crystal center axis is inclined, although a yield of the dislocation-free single crystal are wholly improved, the dislocations exist in the p++ silicon single crystal. This is presumably attributed to the fact that the effect of eliminating the misfit dislocations is small merely by pulling the seed crystal while the seed crystal center axis is inclined relative to the crystal axis [110].

(Example 2)

The silicon single crystals are grown under the same conditions as Example 1 except that the neck length is changed to 400 mm. Table 6 shows the investigation result.

Table 6

|  | seed crystal inclination angle (°) | boron concentration of grown crystal | | |
|---|---|---|---|---|
|  |  | p- | p+ | p++ |
| condition 1 | 0 | Δ | × | × |
| condition 2 | 0.7 | ○ | × | × |
| condition 3 | 1.0 | ○ | Δ | × |
| condition 4 | 5.0 | ○ | ○ | × |
| condition 5 | 10.0 | ○ | ○ | × |

As shown in Table 6, when the neck length is lengthened, the dislocation-free feature can be achieved even in the condition in which the dislocation-free feature cannot be achieved in the neck length of 300 mm.

(Example 3)

The silicon single crystals are grown under the same conditions as Example 1 except that the neck length is changed to 600 mm. Table 7 shows the investigation result.

Table 7

|  | seed crystal inclination angle (°) | boron concentration of grown crystal | | |
|---|---|---|---|---|
|  |  | p- | p+ | p++ |
| condition 1 | 0 | Δ | × | × |
| condition 2 | 0.7 | ○ | Δ | × |
| condition 3 | 1.0 | ○ | ○ | × |
| condition 4 | 5.0 | ○ | ○ | × |
| condition 5 | 10.0 | ○ | ○ | × |

As is evident from Table 7, when the neck length is lengthened, the dislocation-free feature can be achieved even in the condition in which the dislocation-free feature cannot be achieved in Examples 1 and 2. The characteristic of Examples 2 and 3 is that a dislocation-free successful ratio is improved by lengthening the neck length for the growth of the p+ crystal while the dislocation-free successful ratio is not improved even if the neck length is lengthened for the growth of the p++ crystal. It turns out that the improvement effect by the adjustment of the seed crystal inclination angle becomes less as the dopant concentration of the silicon melt is increased.

(Example 4)

The silicon single crystals are grown under the same conditions as Example 1 except that the boron concentration of the seed crystal coincides with the boron concentration of the grown crystal. Table 8 shows the investigation result.

Table 8

|  | seed crystal inclination angle (°) | boron concentration of grown crystal | | |
|---|---|---|---|---|
|  |  | p- | p+ | p++ |
| condition 1 | 0 | Δ | Δ | Δ |
| condition 2 | 0.7 | ○ | ○ | ○ |
| condition 3 | 1.0 | ○ | ○ | ○ |
| condition 4 | 5.0 | ○ | ○ | ○ |
| condition 5 | 10.0 | ○ | ○ | ○ |

As is evident from Table 8, the single crystal growth can be performed in a dislocation-free manner under all the conditions 1 to 5.

(Example 5)

The seed crystal inclination angle is set to 5°, the p++ silicon single crystal is grown under the same conditions as Example 1 using the p++ seed crystal, and the silicon wafers are cut out while the inclination angle relative to the crystal plane (110) is changed in various ways. The epitaxial growth process is performed to each wafer to form the epitaxial layer on the wafer surface, and surface roughness of the epitaxial layer surface is measured.
In the epitaxial growth condition, trichlorosilane (TCS) is used as a source gas to form the epitaxial layer on the wafer surface at a temperature of 1130 °C. The epitaxial layer has a resistivity ρ and a thickness of 3 $\mu$m. Table 9 shows the result. In Table 9, "surface roughness RMS" means micro roughness of the wafer surface defined by the following equation (c), and the micro roughness is measured and evaluated with AFM (Atomic Force Microscopy).

$$RMS = \sqrt{\frac{1}{N} \cdot \sum_{i=1}^{N} zi^2} \qquad \cdots \qquad (c)$$

where

N: number of measuring point,
Zi: surface height at measuring point i

Table 9

|  | inclination angle (°) relative to (111) crystal plane | Inclination direction | surface roughness (RMS) |
|---|---|---|---|
| condition 1 | 0 | - | 0.106 |
| condition 2 | 0.46 | [00-1] | 0.084 |
| condition 3 | 0.48 | [00-1]+20° | 0.075 |
| condition 4 | 0.44 | [-11-1] | 0.162 |
| condition 5 | 0.42 | [-100] | 0.264 |

Table 9 shows that the surface roughness occasionally becomes smaller compared with the surface roughness in the case where wafer surface includes the crystal plane (110) (condition 1 of Table 9). That is, in the case where the inclination angle relative to the crystal plane (110) is optimized, it is presumed that the haze generation is suppressed.

The silicon single crystal production method of the invention is a method specifying a boron concentration of both a silicon melt and a seed crystal dipped in the silicon melt, and an inclination angle relative to a crystal axis [110] of the seed crystal. The silicon single crystal, in which the dislocations are sufficiently eliminated and the center axis is inclined by 0.6° to 10° relative to the crystal axis [110], can be produced by the silicon single crystal production method of the invention. The use of the silicon seed crystal of the invention is suitable to the implementation of the silicon single crystal production method of the invention. According to the silicon wafer production method of the invention in which the silicon single crystal is used, the dislocation-free low-resistance silicon wafer can be produced with the crystal axis orientation [110]. The epitaxial layer in which the haze generation is suppressed can also be formed in the wafer surface.

Accordingly, the silicon single crystal production method, the silicon seed crystal used in the silicon single crystal production method, and the silicon wafer production method of the invention can suitably be used in producing the silicon semiconductor material and device.

**Claims**

1. A method for producing a silicon single crystal by a Czochralski method in which a center axis thereof is inclined by 0.6° to 10° relative to a crystal axis [110], **characterized in that** the silicon single crystal is grown by dipping a silicon seed crystal in a silicon melt, the silicon melt containing boron as a dopant in such a manner that a boron concentration ranges from $6.25 \times 10^{17}$ to $2.5 \times 10^{20}$ atoms/cm$^3$, the silicon seed crystal having a center axis that is inclined by 0.6° to 10° relative to the crystal axis [110] and having the substantially same boron concentration as that of a neck portion formed in the single crystal grown from the silicon melt, **characterized in that** the center axis of the silicon seed crystal is inclined to a direction rotated about a crystal axis <100> perpendicular to the crystal axis [110].

2. The silicon single crystal production method according to claim 1, **characterized in that** the neck portion having a diameter of 4 to 6 mm is formed using the seed crystal in which a diameter of a seed crystal lower end portion is not more than 8 mm, the seed crystal lower end portion being in contact with the silicon melt.

3. The method according to any one of claims 1 or 2, **characterized in that** the silicon single crystal is obliquely cut at an angle corresponding to the seed crystal inclination angle to obtain a silicon wafer whose surface includes a crystal plane (110).

4. The method according to any one of claims 1 or 2, **characterized in that** the silicon single crystal is cut in such a manner to obtain a silicon wafer that a maximum inclination angle becomes not more than $\pm 10°$ relative to a radial direction of the silicon single crystal.

5. The method of claim 3 or 4, **characterized in that** an epitaxial layer is formed on a surface of the silicon wafer.

6. A silicon seed crystal **characterized in that** a boron concentration ranges from $5 \times 10^{17}$ to $2 \times 10^{20}$ atoms/cm$^3$ and a center axis is inclined by 0.6° to 10° relative to a crystal axis [110], **characterized in that** the center axis of the silicon seed crystal is inclined to a direction rotated about a crystal axis <100> perpendicular to the crystal axis [110].

## Patentansprüche

1. Verfahren zur Herstellung eines Siliziumeinkristalls durch ein Czochalski-Verfahren, bei welchem dessen Mittelachse um 0,6 Grad bis 10 Grad bezüglich einer Kristallachse [110] geneigt ist, **dadurch gekennzeichnet, dass** der Siliziumeinkristall gewachsen wird, indem ein Siliziumsaatkristall in eine Siliziumschmelze getaucht wird, wobei die Siliziumschmelze Bor als Dotierstoff in einer derartigen Weise enthält, dass sich eine Borkonzentration zwischen 6,25x10$^{17}$ bis 2,5x10$^{20}$ Atome/cm$^3$ bewegt, wobei der Siliziumsaatkristall eine Mittelachse aufweist, welche um 0,6 Grad bis 10 Grad relativ zu der Kristallachse [110] geneigt ist und im Wesentlichen die gleiche Borkonzentration wie diejenige eines Halsabschnitts, welcher in dem aus der Siliziumschmelze gewachsenen Einkristall ausgebildet ist, aufweist, **dadurch gekennzeichnet, dass** die Mittelachse des Siliziumsaatkristalls zu einer um eine Kristallachse <100> senkrecht zu der Kristallachse [110] rotierten Richtung geneigt ist.

2. Siliziumeinkristallherstellungsverfahren gemäß Anspruch 1, **dadurch gekennzeichnet, dass** der Halsabschnitt mit einem Durchmesser von 4 bis 6 mm unter Benutzung des Saatkristalls, bei welchem ein Durchmesser eines unteren Endabschnitts des Saatkristalls nicht mehr als 8 mm ist, ausgebildet wird, wobei der untere Endabschnitt des Saatkristalls in Kontakt mit der Siliziumschmelze steht.

3. Verfahren gemäß einem der Ansprüche 1 oder 2, **dadurch gekennzeichnet, dass** der Siliziumeinkristall schräg unter einem Winkel entsprechend dem Saatkristallneigungswinkel geschnitten wird, um einen Siliziumwafer zu erhalten, dessen Oberfläche eine (110)-Kristallebene enthält.

4. Verfahren gemäß einem der Ansprüche 1 oder 2, **dadurch gekennzeichnet, dass** der Siliziumeinkristall auf eine derartige Weise geschnitten wird, um einen Siliziumwafer zu erhalten, dass ein maximaler Neigungswinkel nicht mehr als $\pm$ 10 Grad relativ zu einer radialen Richtung des Siliziumeinkristalls wird.

5. Verfahren nach Anspruch 3 oder 4, **dadurch gekennzeichnet, dass** eine Epitaxieschicht auf einer Oberfläche des Siliziumwafers ausgebildet wird.

6. Siliziumsaatkristall, **dadurch gekennzeichnet, dass** eine Borkonzentration von 5x10$^{17}$ bis 2x10$^{20}$ Atome/cm$^3$ reicht und eine Mittelachse um 0,6 Grad bis 10 Grad relativ zu einer Kristallachse [110] geneigt ist, **dadurch gekennzeichnet, dass** die Mittelachse des Siliziumsaatkristalls zu einer um eine Kristallachse <100> senkrecht zu der Kristallachse [110] rotierten Richtung geneigt ist.

## Revendications

1. Procédé de production d'un monocristal de silicium par une méthode Czochralski dans laquelle un axe central de celui-ci est incliné de 0,6 ° à 10 ° par rapport à un axe cristallin [110], **caractérisé en ce que** le monocristal de silicium est mis à croître en immergeant un germe cristallin de silicium dans une matière fondue de silicium, la matière fondue de silicium contenant du bore comme dopant de telle manière qu'une concentration en bore varie de 6,25 x 10$^{17}$ à 2,5 x 10$^{20}$ atomes/cm$^3$, le germe cristallin de silicium ayant un axe central qui est incliné de 0,6 ° à 10 ° par rapport à l'axe cristallin [110] et ayant sensiblement la même concentration en bore que celle d'une portion de col formée dans le monocristal mis à croître à partir de la matière fondue de silicium, **caractérisé en ce que** l'axe central du germe cristallin de silicium est incliné par rapport à une direction tournée autour d'un axe cristallin <100> perpendiculaire à l'axe cristallin [110].

2. Procédé de production de monocristal de silicium selon la revendication 1, **caractérisé en ce que** la portion de col ayant un diamètre de 4 à 6 mm est formée en utilisant le germe cristallin dans lequel un diamètre d'une portion d'extrémité inférieure de germe cristallin est non inférieur à 8 mm, la portion d'extrémité inférieure de germe cristallin étant en contact avec la matière fondue de silicium.

3. Procédé selon l'une quelconque des revendications 1 et 2, **caractérisé en ce que** le monocristal de silicium est coupé à l'oblique à un angle correspondant à l'angle d'inclinaison de germe cristallin pour obtenir une tranche de silicium dont la surface inclut un plan cristallin (110).

4. Procédé selon l'une quelconque des revendications 1 et 2, **caractérisé en ce que** le monocristal de silicium est coupé de telle manière à obtenir une tranche de silicium telle qu'un angle d'inclinaison maximal devient non supérieur à +10 ° par rapport à une direction radiale du monocristal de silicium.

5. Procédé selon la revendication 3 ou 4, **caractérisé en ce qu'**une couche épitaxiale est formée sur une surface de la tranche de silicium.

6. Germe cristallin de silicium **caractérisé en ce qu'**une concentration en bore varie de $5 \times 10^{17}$ à $2 \times 10^{20}$ atomes/cm$^3$ et un axe central est incliné de 0,6 ° à 10 ° par rapport à un axe cristallin [110], **caractérisé en ce que** l'axe central du germe cristallin de silicium est incliné par rapport à une direction tournée autour d'un axe central <100> perpendiculaire à l'axe cristallin [110].

# FIG. 1

9 Seed Crystal Axial Direction
(Pulling Direction of Crystal)

Crystal Orientation <110>

θ°

10

4 Slip Dislocation
Eliminated Portion

{111}

{110}

{111}

{100}

{110}

{100}

{111}

{110}

{110}

{100}

{111}

{110}

{110}

{111}

{110}

{100}

7 Silicon Crystal

{100}

8 Edge Line Direction
of {111} Plane

5 Slip Dislocations

6a Melt Surfacce

6 Melt

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003313089 A
- EP 1498516 A1
- JP 9255490 A
- JP 2001240493 A